# EUROPÄISCHE PATENTSCHRIFT

(11) **EP 1 217 715 B1**
(45) Veröffentlichungstag und Bekanntmachung des Hinweises auf die Patenterteilung: **07.07.2004**
(21) Anmeldenummer: 01129301.6
(22) Anmeldetag: 13.12.2001
(51) Int. Cl.: H02K 5/00, H02K 11/04, H02K 5/167, H02K 1/18, H02K 5/22, F04D 25/06

(54) **Antriebseinheit für Gebläse in Fahrzeugen**
Drive unit for a fan in vehicles
Entrainement de ventilateur pour véhicules

(30) Priorität: 20.12.2000 DE 10063619
(43) Veröffentlichungstag der Anmeldung: 26.06.2002
(73) Patentinhaber: TRW Automotive Electronics & Components GmbH & Co. KG, 78315 Radolfzell (DE)
(72) Erfinder: Peter, Cornelius, 77815 Bühl (DE); von der Heide, Johann, 78713 Schrammberg (DE); Tschiskale, Ega, 78333 Stockach (DE); Baltrusch, Daniel, 78359 Orsingen-Nenzingen (DE)
(74) Vertreter: Degwert, Hartmut, Dipl.-Phys.

(56) Entgegenhaltungen:
- EP-A- 0 784 369
- DE-A- 19 727 165
- US-A- 5 798 589
- US-A- 5 898 988
- US-A- 5 962 938

## Beschreibung

Die Erfindung betrifft eine Antriebseinheit für Gebläse in Fahrzeugen gemäß dem Oberbegriff von Anspruch 1.

Ein Gebläse für Kraftfahrzeuge, dessen Antriebseinheit einen bürstenlosen Gleichstrommotor mit Außenläufer aufweist, ist bereits aus der US 5,588,814 bekannt. Die Antriebseinheit dieses Gebläses ist in dessen das Lüfterrad umgebenden Sammel- und Verteilerkasten integriert. Für die Lagerung des Außenläufers, der mit dem Lüfterrad zu einer baulichen Einheit zusammengefasst ist, werden Bodenteile des Sammel- und Verteilerkastens genutzt. Die von dem Lüfterrad angesaugte Luft ist gegen die Antriebseinheit gerichtet. Eine von der angesaugten Luft abgezweigte Kühlluftströmung wird den auf einer Leiterplatte unterhalb der Antriebseinheit angeordneten Leistungshalbleitern der Ansteuerelektronik zugeführt.

Aus der gattungsgemäßen US-A-5,962,938 ist eine Antriebseinheit für Gebläse bekannt, deren Ansteuerelektronik von einem Gehäuse umschlossen ist. Das Oberteil des Gehäuses trägt einen Gleichstrommotor, dessen Rotor als Außenläufer ausgebildet ist.

Aus der UA-A-5,898,988 ist eine Antriebseinheit für Gebläse in Fahrzeugen bekannt, die einen Gleichstrommotor mit einem als Außenläufer ausgebildeten Rotor und eine in einer Stützstruktur angeordnete Ansteuerelektronik aufweist. In der Stützstruktur und in dem Rotor sind Luftdurchtrittsöffnungen vorgesehen, durch die Luft vom Steuerschaltkreis nach außen gesogen wird.

In der US-A-5,798,589 ist eine Antriebseinheit für Gebläse in Fahrzeugen gezeigt, deren Ansteuerelektronik in einem Gehäuse auf einer Leiterplatte angeordnet ist. Zur Kühlung von auf der Leiterplatte montierten Feldeffekttransistoren ist eine eine Öffnung des Gehäuses verschließende wärmeabführende Platte mit Kühlrippen vorgesehen.

Aus der DE-A-197 27 165 ist eine Antriebseinheit bekannt, die ein Gehäuse aufweist, in dem eine Leiterplatte mit mehreren Leistungstransistoren angeordnet ist. Zur Abführung der an den Leistungstransistoren entstehenden Wärme liegen die Kühlflächen der Transistoren plan auf einer Fläche eines Trägers auf. Der Träger weist eine Vielzahl von konzentrischen Kühlrippen auf, die von einer vom Rotor des Motors verursachten Luftströmung umströmt werden. Die Transistoren sind ferner von einer gut wärmeleitenden Vergußmasse umgeben.

Die erfindungsgemäße Antriebseinheit für Gebläse in Fahrzeugen ist eine autonome besonders leistungsfahige, Baugruppe, die auf keine Strukturteile des Sammel- und Verteilerkastens zur Lagerung des Gleichstrommotors oder zur Aufnahme der Ansteuerelektronik angewiesen ist. Dies wird durch dei im kennzeichnenden Teil von Anspruch 1 angegebenen Merkmale erreicht. Da die Antriebseinheit eine autonome Baugruppe bildet, kann sie mit verschiedensten Gehäuseteilen und Lüfterrädern zu einem Gebläse kombiniert werden. Das die Ansteuerelektronik umschließende Gehäuse wird auf der Saugseite des Gebläses eingebaut, damit die angesaugte Luft durch Eintrittsöffnungen des Gehäuses eingeleitet und zur Kühlung sowohl der Leistungshalbleiter der Ansteuerelektronik als auch der Bestandteile des Gleichstrommotors genutzt werden kann.

Das Gehäuse weist eine einteilig angeformte Lagerhülse zur Lagerung des Rotors des Gleichstrommotors auf, der ein Außenläufer ist. Die Lagerhülse nimmt die Lager zur Lagerung der Lagerwelle des Außenläufers auf. Sie bildet aber auch einen Führungskanal für die Kühlluftströmung, die zur Kühlung der Leistungshalbleiter der Ansteuerelektronik benötigt wird und durch Lufteintrittsöffnungen des Gehäuses eintreten kann, parallel zu den Luftströmen zwischen Rotor und Stator des Gleichstrommotors, die sich durch die Druckdifferenz zwischen Saugseite und Druckseite des Gebläses ausbilden.

Die Ansteuerelektronik weist einen Leistungsteil und einen Steuerteil auf, die auf getrennten Leiterplatten aufgebaut sind, von denen die Leiterplatte für den Leistungsteil durch Umspritzen einer aus einem Metallblech ausgestanzten Leiterstruktur mit Kunststoff gebildet ist. Der Leistungsteil kann daher extrem hohe Ströme verarbeiten, ohne die empfindlichen Bauteile auf der Leiterplatte des Steuerteils zu gefährden.

Weitere Merkmale und Vorteile der Erfindung ergeben sich aus der folgenden Beschreibung einer bevorzugten Ausführungsform und aus den beigefügten Zeichnungen, auf die Bezug genommen wird. In den Zeichnungen zeigen:

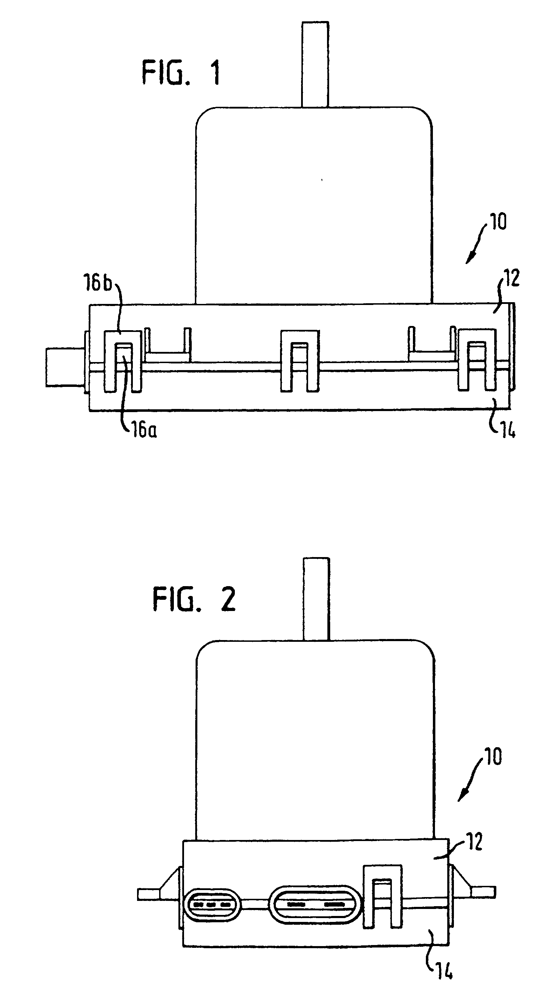

- - Figur 1: eine schematische Seitenansicht einer Antriebseinheit für Gebläse;
- - Figur 2: eine Stirnansicht der Antriebseinheit;
- - Figur 3: eine Draufsicht der Antriebseinheit;
- - Figur 4: einen Axialschnitt der Antriebseinheit; und
- - Figur 5: eine perspektivische Illustrationsansicht einer Leiterplatte der Antriebseinheit.

Die Antriebseinheit hat als tragendes Bauteil ein allgemein mit 10 bezeichnetes Gehäuse aus Kunststoff. Das allgemein quaderförmige Gehäuse 10 besteht aus einem Oberteil 12 und einem Unterteil 14. Oberteil 12 und Unterteil 14 sind durch Rastverbindungselemente 16a am Oberteil 12 und 16b am Unterteil 14 miteinander verbunden. Das Oberteil 12 hat seitlich abstehende Montagelaschen 18, an denen die gesamte Antriebseinheit in einem Gebläsegehäuse aufgehängt bzw. befestigt wird. Das Oberteil 12 des Gehäuses 10 ist somit das eigentlich tragende Bauteil.

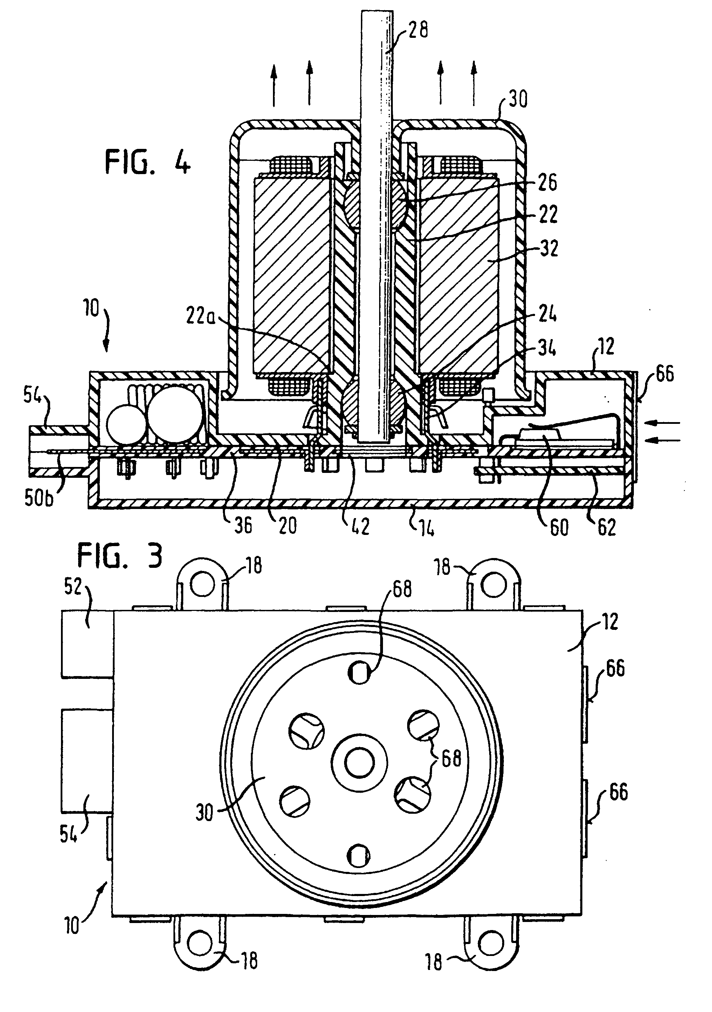

Das Oberteil 12 des Gehäuses 10 hat, wie aus Figur 4 ersichtlich, an seiner Oberseite eine allgemein zylinderförmige Einsenkung 20. Vom Boden dieser Einsenkung aus ragt eine einteilig angeformte Lagerhülse 22 senkrecht nach oben. An den axialen Enden der Lagerhülse 22 sind Lager 24, 26 für eine Lagerwelle 28 eingesetzt. Die Lagerwelle 28 trägt einen allgemein topfförmigen, als Außenläufer ausgebildeten Rotor 30 eines Gleichstrommotors, dessen Stator 32 hohlzylindrisch ausgebildet und auf die Lagerhülse 22 aufgeschoben ist. Die axiale Position des Stators 32 wird durch Aufsitzen seines unteren Innenumfangs auf einer Schulter 22a der Lagerhülse 22 definiert. Bei dem Gleichstrommotor handelt es sich insbesondere um einen bürstenlosen 4-Phasen-Gleichstrommotor.

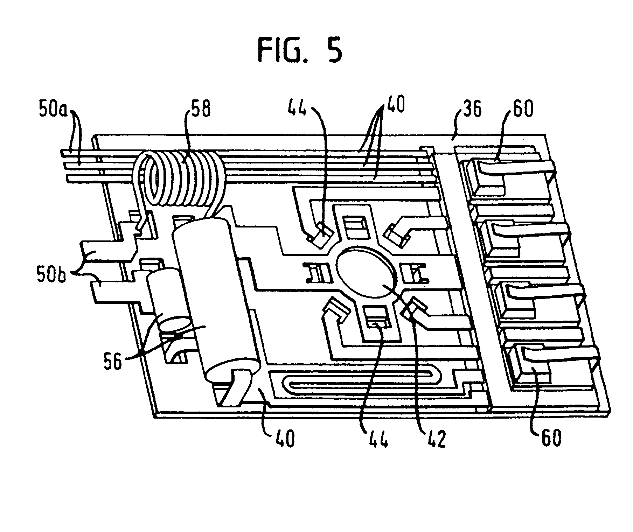

Von den Wicklungen des Stators 32 sind massive Anschlußfahnen 34 am Umfang der Lagerhülse 22 entlang gegen den Boden der Einsenkung 20 des Oberteils 12 und durch die Lagerhülse 22 umgebende Öffnungen in das Innere des Gehäuses 10 hineingeführt. Das Gehäuse 10 umschließt eine erste Leiterplatte 36, die sich über die gesamte Breite des Gehäuses erstreckt. Diese Leiterplatte 36 ist durch Umspritzen einer massiven Leiterstruktur mit Kunststoff gebildet. Die massive Leiterstruktur besteht aus streifenförmigen Leiterbahnen 40 (Figur 5), die aus einem Metallblech ausgestanzt sind. Die Leiterplatte 36 hat einen kreisförmigen Durchbruch 42, der koaxial zur Lagerhülse 22 angeordnet wird. Dieser Durchbruch 42 ist von Öffnungen 44 umgeben, deren Anordnung den in das Gehäuse hineinragenden Enden der Anschlußfahnen 34 des Stators 32 entspricht. Wegen der vierpoligen Ausführung des Gleichstrommotors sind acht solche Öffnungen 44 vorhanden, an denen jeweils eine Leiterbahn 40 endet. Die Enden der Anschlußfahnen 34 sind an den Öffnungen 44 mit den entsprechenden Leiterbahnen durch Löten verbunden.

An einer Schmalseite der Leiterplatte 36 sind einige der Leiterbahnen 40 als Kontaktfahnen 50a und 50b herausgeführt. Die Kontaktfahnen 50a und 50b ragen an einer schmalen Stirnfläche aus dem Gehäuse 10 heraus und sind von angeformten Steckerkragen 52, 54 umgeben. Die Kontaktfahnen 50a sind kleiner dimensioniert als die Kontaktfahnen 50b und dienen dem Anschluß von Sensorund Steuerleitungen, während die Kontaktfahnen 50b der Stromversorgung dienen.

In dem an die Kontaktfahnen 50a, 50b angrenzenden Innenraum des Gehäuses 10 sind relativ großvolumige Siebbauteile, wie Kondensatoren 56 und eine Drossel 58 angeordnet. Am entgegengesetzten Ende der Leiterplatte 36 sind vier Leistungshalbleiter 60 angeordnet. Die Leistungshalbleiter 60 sitzen mit ihrer Kühlfahne unmittelbar auf einer freiliegenden Metallfläche der Leiterbahnen 40 auf. Sie stehen mit ihnen in elektrisch und thermisch leitendem Kontakt. Die Anschlußfahnen der Leistungshalbleiter 60 sind senkrecht gegen die Leiterplatte 36 abgebogen und ragen durch entsprechende Öffnungen der Leiterplatte hindurch bis zu einer zweiten Leiterplatte 62, die parallel unter der ersten Leiterplatte 36 angeordnet ist. Auf dieser zweiten Leiterplatte 62 ist der Steuerteil der Ansteuerelektronik des Gleichstrommotors aufgebaut, während auf der ersten Leiterplatte 36 der Leistungsteil der Ansteuerelektronik aufgebaut ist.

An der den Kontaktfahnen 50a, 50b gegenüberliegenden Schmalseite des Gehäuses 10, neben den Leistungshalbleitern 60, sind Lufteintrittsöffnungen 66 angeordnet. Ferner sind in der Stirnfläche des topfförmigen Rotors 30 Luftaustrittsöffnungen 68 vorgesehen. Die beschriebene Antriebseinheit wird im Gehäuse des Gebläses derart angeordnet, daß die Lufteintrittsöffnungen 66 auf der Saugseite des Gebläses gelegen sind. Das Lüfterrad des Gebläses wird unmittelbar auf das vom Rotor 30 abstehende Ende der Lagerwelle 28 aufgesetzt und auf dieser befestigt. Im Betrieb wird, da die Antriebseinheit sich auf der Saugseite des Gebläses befindet, eine Luftströmung durch die Lufteintrittsöffnungen 66 des Gehäuses 10 in dessen Inneres eingeleitet und an den Leistungshalbleitern 60 vorbeigeführt. Die Luft strömt dann durch die auch als Führungskanal wirkende Lagerhülse 22 zur Stirnseite des Rotors 30 und tritt durch dessen Öffnungen 68 aus. Durch den Kühlluftstrom werden die Leistungselektronik wie auch die Wicklungen des Stators 32 gekühlt.

Die beschriebene Antriebseinheit ist überaus kompakt und dennoch sehr leistungsfähig, insbesondere wegen der guten Kühlung aller thermisch beanspruchten Bauteile und wegen des mechanisch robusten Aufbaus. Eine besonders hohe Steifigkeit der Baugruppe ergibt sich dadurch, daß die Leiterplatte 36 im Inneren des Gehäuses 10 an der Unterseite ihres Oberteils 12 anliegt und damit ein axiales Widerlager für den Stator 32 bildet. Da außer dem Oberteil 12 des Gehäuses 10 keine tragenden Bauteile benötigt werden, ergibt sich eine sehr einfache und dennoch robuste mechanische Konstruktion. Bei der Montage werden die verschiedenen Bestandteile der Antriebseinheit im wesentlichen in Axialrichtung des Rotors 30 zusammengesetzt und dann aneinander befestigt, so daß sich auch eine vereinfachte und maschinell durchführbare Montage ergibt.

## Patentansprüche

1. Antriebseinheit für Gebläse in Fahrzeugen, mit einem bürstenlosen Gleichstrommotor (30, 32) und einer Ansteuerelektronik (36, 62), die von einem Gehäuse (10) aus Kunststoff umschlossen ist, das ein Oberteil aufweist, das den Gleichstrommotor (30, 32) trägt, wobei das Gehäuse (10) eine Lagerhülse (22) zur Lagerung des als allgemein topfförmigen Außenläufer ausgebildeten Rotors des Gleichstrommotors aufweist,
**dadurch gekennzeichnet, daß** die Lagerhülse (22) einteilig am Gehäuse (10) angeformt ist, daß die Ansteuerelektronik einen Leistungsteil und einen Steuerteil aufweist, die auf getrennten Leiterplatten (36, 62) aufgebaut sind, von denen die Leiterplatte (36) für den Leistungsteil durch Umspritzen einer aus einem Metallblech ausgestanzten Leiterstruktur (40) mit Kunststoff gebildet ist und freiliegende Metallflächen der Leiterstruktur (40) aufweist, an denen Leistungshalbleiter (60) in wärmeübertragendem Kontakt anliegen, und wobei das Gehäuse (10) Lufteintrittsöffnungen (66) neben den Leistungshalbleitern aufweist, die Lagerhülse (22) einen Führungskanal für die durch die Lufteintrittsöffnungen (66) des Gehäuses (10) eingetretene Kühlluft bildet und der Rotor (30) des Gleichstrommotors an einer Stirnfläche Luftaustrittsöffnungen (68) aufweist.

2. Antriebseinheit nach Anspruch 1, **dadurch gekennzeichnet, dass** das auf der Saugseite des Gebläses anzuordnende Gehäuse (10) Lufteintrittsöffnungen (66) für die Kühlung der Bauteile (60) der Ansteuerelektronik (36, 62) und für die Bestandteile (32) des Gleichstrommotors aufweist.

3. Antriebseinheit nach Anspruch 2, **dadurch gekennzeichnet, dass** der Außenläufer (30) allgemein topfförmig ausgebildet ist und an einer Stirnseite auf einer Lagerwelle (28) befestigt ist.

4. Antriebseinheit nach Anspruch 3, **dadurch gekennzeichnet, dass** die Lagerwelle (28) über in die Lagerhülse (22) eingesetzte Lager (24, 26) in der Lagerhülse (22) drehbar gelagert ist.

5. Antriebseinheit nach einem der Ansprüche 1 bis 4, **dadurch gekennzeichnet, dass** die Lagerhülse (22) vom hohlzylinderförmigen Stator (32) des Gleichstrommotors umgeben ist.

6. Antriebseinheit nach Anspruch 5, **dadurch gekennzeichnet, dass** die Lagerhülse (22) eine Schulter (22a) aufweist, auf der ein Innenumfangsrand des Stators (32) aufsitzt.

7. Antriebseinheit nach Anspruch 6, **dadurch gekennzeichnet, dass** der Stator (32) mit axial abstehenden Anschlussfahnen (34) versehen ist, die durch die Lagerhülse (22) umgebende Öffnungen des Gehäuses (10) ragen und mit einer im Inneren des Gehäuses (10) angeordneten Leiterplatte (36) verbindbar sind.

8. Antriebseinheit nach einem der Ansprüche 3 bis 7, **dadurch gekennzeichnet, dass** das Gehäuse (10) eine die Lagerhülse (22) umgebende zylindrische Einsenkung (20) aufweist, in die der von der Stirnfläche des Außenläufers (30) abgewandte Umfangsrand dieses Außenläufers (30) hineinragt.

9. Antriebseinheit nach einem der Ansprüche 1 bis 8, **dadurch gekennzeichnet, dass** das Gehäuse (10) zweiteilig mit einem die Lagerhülse (22) aufweisenden tragenden Oberteil (12) und einem eine offene Hauptseite des Oberteils (12) verschließenden Unterteil (14) ausgebildet ist.

10. Antriebseinheit nach Anspruch 9, **dadurch gekennzeichnet, dass** das Oberteil (12) seitlich abstehende Montagelaschen (18) aufweist.

11. Antriebseinheit nach Anspruch 9, **dadurch gekennzeichnet, dass** das Unterteil (14) an dem Oberteil (12) durch Verrasten befestigt ist.

12. Antriebseinheit nach Anspruch 1, **dadurch gekennzeichnet, dass** die Leiterstruktur (40) Kontaktfahnen (50a, 50b) aufweist, die aus einem Rand der Leiterplatte (36) herausragen.

13. Antriebseinheit nach Anspruch 12, **dadurch gekennzeichnet, dass** die Kontaktfahnen (50a, 50b) auf der Außenseite des Gehäuses (10) herausragen und von am Gehäuse (10) angeformten Steckerkragen (52, 54) umgeben sind.

14. Antriebseinheit nach Anspruch 1, **dadurch gekennzeichnet, dass** die Leiterplatte ringförmig angeordnete Verbindungsöffnungen (44) aufweist, in die Anschlußfahnen (34) eines Stators (32) des Gleichstrommotors einsetzbar sind und an denen Leiterbahnen (40) der Leiterstruktur anschließen.

15. Antriebseinheit nach Anspruch 1, **dadurch gekennzeichnet, dass** die Leistungshalbleiter (60) abgebogene Anschlussfahnen aufweisen, die durch Öffnungen in der Leiterplatte (36) des Leistungsteils ragen und mit der parallel darunterliegenden Leiterplatte (62) des Steuerteils verbunden sind.

## Claims

1. A drive unit for a fan in a vehicle, comprising a brushless DC electric motor (30, 32) and an electronic actuation system (36, 62) enclosed by a housing (10) which is made of plastics and has an upper part which supports the DC electric motor (30, 32), the housing (10) having a bearing sleeve (22) for mounting the rotor of the DC electric motor, the rotor being configured as a generally pot-shaped external rotor,
**characterized in that** the bearing sleeve (22) is integrally molded with the housing (10), that the electronic actuation system has a power part and a control part, which are mounted on separate printed circuit boards (36, 62), of which the printed circuit board (36) for the power part is formed by injection-molding with plastic around a conductor structure (40) stamped out of sheet metal and has exposed metal surfaces of the conductor structure (40) which are contacted by power semiconductors (60) for heat transfer, and the housing (10) having air inlet openings (66) next to the power semiconductors, the bearing sleeve (22) forming a guide channel for the cooling air that has entered through the air inlet openings (66) of the housing (10), and the rotor (30) of the DC electric motor having air outlet openings (68) on an end face.

2. The drive unit according to claim 1, **characterized in that** the housing (10), which is to be arranged on the suction side of the fan, has air inlet openings (66) for cooling the component parts (60) of the electronic actuation system (36, 62) and for the components (32) of the DC electric motor.

3. The drive unit according to claim 2, **characterized in that** the external rotor (30) is configured generally pot-shaped and has an end face attached to a bearing shaft (28).

4. The drive unit according to claim 3, **characterized in that** the bearing shaft (28) is rotatably mounted in the bearing sleeve (22) by means of bearings (24, 26) inserted in the bearing sleeve (22).

5. The drive unit according to any of claims 1 to 4, **characterized in that** the bearing sleeve (22) is surrounded by the hollow-cylindrical stator (32) of the DC electric motor.

6. The drive unit according to claim 5, **characterized in that** the bearing sleeve (22) has a shoulder (22a) on which an inner circumferential edge of the stator (32) bears.

7. The drive unit according to claim 6, **characterized in that** the stator (32) is provided with axially projecting connection tags (34) that extend through openings of the housing (10) surrounding the bearing sleeve (22) and that can be connected to a printed circuit board (36) arranged in the interior of the housing (10).

8. The drive unit according to any of claims 3 to 7, **characterized in that** the housing (10) has a cylindrical depression (20) surrounding the bearing sleeve (22) and into which the circumferential edge of the external rotor (30) facing away from the end face of this external rotor (30) protrudes.

9. The drive unit according to any of claims 1 to 8, **characterized in that** the housing (10) is formed of two parts, with a supporting upper part (12) that comprises the bearing sleeve (22) and a lower part (14) that closes an open main side of the upper part (12).

10. The drive unit according to claim 9, **characterized in that** the upper part (12) has laterally projecting assembly tabs (18).

11. The drive unit according to claim 9, **characterized in that** the lower part (14) is secured to the upper part (12) by latching.

12. The drive unit according to claim 1, **characterized in that** the conductor structure (40) has contact tags (50a, 50b) that project from an edge of the printed circuit board (36).

13. The drive unit according to claim 12, **characterized in that** the contact tags (50a, 50b) project from the outside of the housing (10) and are surrounded by plug collars (52, 54) integrally molded with the housing (10).

14. The drive unit according to claim 1, **characterized in that** the printed circuit board has connection openings (44) arranged in a circle, connection tags (34) of a stator (32) of the DC electric motor being adapted to be inserted into the connection openings (44), and conductor tracks (40) of the conductor structure being adjacent to the connection openings (44).

15. The drive unit according to claim 1, **characterized in that** the power semiconductors (60) have bent connection tags that extend through openings in the circuit board (36) of the power part and are connected to the control part circuit board (62) that is arranged in parallel underneath.

## Revendications

1. Unité d'entraînement pour ventilateur dans des véhicules, comportant un moteur à courant continu sans balai (30, 32) et un système de pilotage électronique (36, 62) qui est enfermé dans un boîtier (10) en matière plastique présentant une partie supérieure qui porte le moteur à courant continu (30, 32), le boîtier (10) présentant un manchon de soutien (22) pour soutenir le rotor du moteur à courant continu, lequel est réalisé en tant que rotor extérieur généralement en forme de pot,
**caractérisée en ce que** le coussinet de soutien (22) est moulé d'un seul tenant sur le boîtier (10), **en ce que** le système de pilotage présente une partie puissance et une partie commande qui sont montées sur des cartes imprimées (36, 62) séparées, dont la carte imprimée (36) pour la partie puissance est formée par extrusion d'une structure conductrice (40) estampée dans une plaque métallique avec de la matière plastique et présente des surfaces métalliques dénudées de la structure conductrice (40), sur lesquelles des semi-conducteurs de puissance sont posés en contact transmettant la chaleur, et le boîtier (10) présentant des orifices d'admission d'air (66) à côté des semi-conducteurs, le manchon de soutien (22) formant un canal de guidage pour l'air de refroidissement entrant par les orifices d'admission d'air (66) du boîtier (10) et le rotor (30) du moteur à courant continu présentant des orifices de sortie d'air (68) sur une face frontale.

2. Unité d'entraînement selon la revendication 1, **caractérisée en ce que** le boîtier (10) à agencer sur le côté du ventilateur présente des orifices d'admission d'air (66) pour le refroidissement des composants (60) du système électronique de pilotage (36, 62) et pour les éléments (32) du moteur à courant continu.

3. Unité d'entraînement selon la revendication 2, **caractérisée en ce que** le rotor extérieur (30) est réalisé généralement en forme de pot et est fixé sur l'une de ses faces à un arbre de soutien (28).

4. Unité d'entraînement selon la revendication 3, **caractérisée en ce que** l'arbre de soutien (28) est monté à rotation dans le manchon de soutien (22) par l'intermédiaire de paliers (24, 26).

5. Unité d'entraînement selon l'une des revendications 1 à 4, **caractérisée en ce que** le manchon de soutien (22) est entouré par le stator (32) en forme de cylindre creux, du moteur à courant continu.

6. Unité d'entraînement selon la revendication 6, **caractérisée en ce que** le manchon de soutien (22) présente un épaulement (22a) sur lequel s'appuie un bord périphérique intérieur du stator (32).

7. Unité d'entraînement selon la revendication 6, **caractérisée en ce que** le stator (32) est pourvu de barrettes de connexion (34) en dépassement axial qui font saillie à travers des orifices du boîtier (10) entourant le manchon de soutien (22) et qui peuvent être reliées à une carte imprimée (36) agencée à l'intérieur du boîtier (10).

8. Unité d'entraînement selon l'une des revendications 3 à 7, **caractérisée en ce que** le boîtier (10) présente un renfoncement (20) cylindrique entourant le manchon de soutien (22), dans lequel fait saillie le bord périphérique du rotor extérieur (30) détourné de la surface frontale de ce rotor extérieur (30).

9. Unité d'entraînement selon l'une des revendications 1 à 8, **caractérisée en ce que** le boîtier (10) est réalisé en deux parties avec une partie supérieure (12) présentant et portant le manchon de soutien (22) et une partie inférieure (14) fermant un côté principal ouvert de la partie supérieure (12).

10. Unité d'entraînement selon la revendication 9, **caractérisée en ce que** la partie supérieure (12) présente des pattes de montage (18) dépassant latéralement.

11. Unité d'entraînement selon la revendication 9, **caractérisée en ce que** la partie inférieure (14) est fixée sur la partie supérieure par enclenchement.

12. Unité d'entraînement selon la revendication 1, **caractérisée en ce que** la structure conductrice (40) présente des barrettes de contact (50a, 50b) qui dépassent d'un bord de la carte imprimée (36).

13. Unité d'entraînement selon la revendication 12, **caractérisée en ce que** les barrettes de contact (50a, 50b) font saillie sur la face extérieure du boîtier (10) et sont entourées de collets de connexion (52, 54) moulés sur le boîtier (10).

14. Unité d'entraînement selon la revendication 1, **caractérisée en ce que** la carte imprimée présente des orifices de connexion (44) agencés de manière annulaire dans lesquels peuvent être insérées des barrettes de connexion (34) d'un stator (32) du moteur à courant continu et auxquels sont raccordées des pistes conductrices (40) de la structure conductrice.

15. Unité d'entraînement selon la revendication 1, **caractérisée en ce que** les semi-conducteurs de puissance (60) présentent des barrettes de connexion repliées qui font saillie à travers des orifices pratiqués dans la carte imprimée (36) de la partie puissance et qui sont reliées à la carte imprimée (62) de la partie commande, qui est située au-dessous.
